# EUROPEAN PATENT SPECIFICATION

(11) **EP 2 457 028 B1**
(45) Date of publication and mention of the grant of the patent: **13.02.2019**
(21) Application number: 10801970.4
(22) Date of filing: 22.07.2010
(51) Int. Cl.: G05B 13/02, G05B 15/02, G05B 9/03, H05K 7/20, F25B 49/02

(54) **REDUNDANT COOLING METHOD AND SYSTEM**
REDUNDANTES KÜHLVERFAHREN UND -SYSTEM
PROCÉDÉ ET SYSTÈME DE REFROIDISSEMENT DU TYPE REDONDANT

(30) Priority: 23.07.2009 US 508429
(43) Date of publication of application: 30.05.2012
(73) Proprietor: Dawes, Warwick Graham Andrew, Midlevels, Hong Kong (CN)
(72) Inventor: Dawes, Warwick Graham Andrew, Midlevels, Hong Kong (CN)
(74) Representative: Carpmael, Robert Maurice Charles
(86) International application number: PCT/CN2010/075390
(87) International publication number: WO 2011/009411

(56) References cited:
- CN-A- 1 573 246
- CN-A- 101 240 936
- CN-A- 101 240 936
- CN-A- 101 438 109
- CN-A- 101 438 109
- JP-A- 9 119 736
- US-A1- 2003 230 098

## Description

### TECHNICAL FIELD

The embodiments disclosed herein relate generally to air handling and cooling systems. More specifically, the embodiments relate to an apparatus and method for use in redundant cooling systems for electronic equipment.

### BACKGROUND

A known method for cooling or reducing excessive heat from heat-generating electronic equipment during operation is providing air conditioners or other air cooling system adjacent to the respective electronic components. Without the use of reliable cooling systems, the electronic components can be damaged by excessive heat build up, or operation can be interrupted by internal protection mechanisms which protect against excessively high temperatures, neither situation is desirable for critical applications.

Currently, critical electronic and electrical related applications necessitate the use of redundant air-cooling systems whereby there are at least two air-cooling units in an N + 1 configuration. At least one unit is configured to provide the required air-cooling and at least another additional unit is configured such that it can immediately carry out the task of the first air-cooling unit in the event that the first air-cooling unit encounters technical failure or similar during use.

A redundant system is preferred in many applications as it ensures that the overall operation is maintained in the case of a failure of at least one of the individual air-cooling units. Conceivably, there may be provided more than two air-cooling units or subsystems within the redundant system, such as 2 + 1 configuration, 3 + 1 configuration, 3 + 2 configuration and so forth, dependent on the level of modularity and redundancy required.

A simple implementation of a 1 + 1 redundant cooling system would be where two independent cooling systems (units), each individually and independently able to meet the total required cooling requirements, are placed adjacent to the equipment to be cooled. The unit with a lower temperature setpoint is designated as the active unit and the unit with a higher, but still acceptable, temperature setpoint is designated as the standby unit. If the active unit is operating correctly, it will maintain the temperature adjacent to the equipment to be cooled at the lower setpoint causing the standby unit with the higher setpoint to remain inactive. Should the active unit not be able to maintain the temperature at the lower setpoint due to some fault condition, the temperature adjacent to the equipment to be cooled will rise to the higher setpoint, so activating the standby machine and ensuring continued cooling, albeit at a somewhat higher temperature.

This simple redundant implementation, while effective at providing failsafe cooling, has a number of drawbacks, which have lead to some solutions in the art.

The simple redundant implementation operates one cooling unit until it fails, whereupon the second cooling unit is activated. This is not optimum for the overall life of the cooling system, so methods and systems have been derived to alternate the standby and active units such that they experience even wear over the life of the systems. Controllers which implement this function are generally called lead-lag controllers. In addition to alternating operation between the active and standby units, the lead-lag controllers also need to activate the standby unit in case of a fault in the currently active unit.

In a further improvement on the simple redundant implementation, the lead-lag controllers normally provide a method of alerting service personnel that one of the cooling units has failed and needs repair or replacement - failure to repair the fault in a timely manner could cause the entire system to fail should the second cooling unit fail before the other unit is repaired.

Although the lead-lag controllers overcome some of the drawbacks of the simple redundant implementation, they are generally not able to optimize the energy efficiency of the cooling system, nor do they fully optimize the overall life of the cooling system. Failure of the lead-lag controller itself can in some cases also lead to a failure of the overall cooling system, diminishing the single fault immunity of the redundant system.

CN 101438109 describes a method of implementing a redundant cooling system.

The disclosed embodiments are directed toward overcoming one or more of the problems discussed above.

### SUMMARY

According to a first aspect of the present invention, there is provided a method for use in a redundant cooling system as defined in claim 1. It may include the steps of: providing a plurality of air cooling units adjacent to the electronic equipment to be cooled, whereby each of the said air cooling units is able to independently control the temperature of the adjacent space up to its maximum capacity; equipping the cooling system with sufficient air cooling units such that the requisite cooling for the electronic equipment remains available in the case of failure of at least one of the said air cooling units; a means for notifying service personnel in the case of failure of at least one of the said air cooling units; determining the operating point for each of the said cooling units which will provide the overall requisite cooling, while minimizing the overall energy consumption and/or maximizing the life of the system; and operating and controlling said plurality of air cooling units based on the determined optimum operating conditions for each of the air cooling units; a means for powering each air cooling unit from a backup power source should the primary power source exceed specified conditions.

Each of the plurality of air cooling units includes a compressor which can be controlled in such a way as to vary the refrigerant flowing in the circuit and hence control the cooling capacity of the unit. They may include a heat exchanger and fan for transferring heat from the air adjacent to the electronic equipment to be cooled to the refrigerant; a heat exchanger and fan for transferring heat from the refrigerant to air outside the space to be cooled; an expansion device to meter the refrigerant flow; and a controller which measures the temperature of the air adjacent to the equipment to be cooled and controls the compressor and fans in order to maintain the temperature and humidity of the air at, or near, the setpoint; a means for the controller to share information about the unit's operating conditions such that the optimum operating point for the overall system can be determined; a means to adjust the unit's operating point to the determined optimum operating point.

The present invention also provides a system as defined in claim 13.

Preferred features are defined in the dependent claims.

### BRIEF DESCRIPTION OF THE DRAWINGS

FIG. 1 is a schematic diagram of an air-cooling system with air-cooling units as described herein.
FIG. 2 is a schematic diagram of the elements of one of the air-cooling units.
FIG. 3 is a graph which plots the energy efficiency ratio (EER) against heat load for the air-cooling units arranged as described herein.
FIG. 4 is a block diagram of the controller in each of the air-cooling units.
FIG. 5 is a flow chart representation of a method for averaging the temperature feedback from the cooling units.
FIG. 6 is a flow chart representation of a method for switching between Linear and On/off modes of operation.
FIG. 7 is a schematic diagram of a power circuit for an air-cooling unit and power converter unit as described herein.

### DETAILED DESCRIPTION

Unless otherwise indicated, all numbers expressing quantities of ingredients, dimensions reaction conditions and so forth used in the specification and claims are to be understood as being modified in all instances by the term "about".

In this application and the claims, the use of the singular includes the plural unless specifically stated otherwise. In addition, use of "or" means "and/or" unless stated otherwise. Moreover, the use of the term "including", as well as other forms, such as "includes" and "included", is not limiting. Also, terms such as "element" or "component" encompass both elements and components comprising one unit and elements and components that comprise more than one unit unless specifically stated otherwise. The term "compressor" refers to a compressor motor and compressor and the term "fan" to a fan motor and fan, unless otherwise stated.

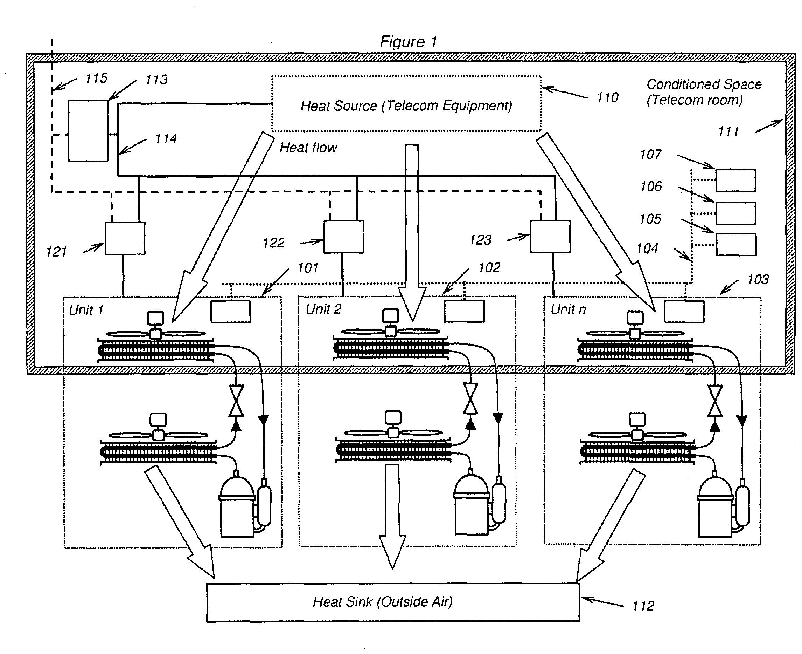

In accordance with one embodiment as shown in FIG. 1, there is provided a cooling system comprised of at least two independent air-cooling subsystems or units (101, 102, 103), whereby each cooling unit includes at least one independent air cooling means, and each is able to independently control the temperature of the conditioned space (111) for a heat load of up to its maximum rated capacity. Each unit (101, 102, 103) is operably coupled to the electronic equipment (110) to be cooled via the air in the conditioned space (111) such that it is able to cool the electronic equipment (110) and reject the heat to the air outside the conditioned space (112). The number (N) of cooling units (101, 102, 103) included in the cooling system is selected such that N-1 cooling units have sufficient cooling capacity to meet the total cooling requirements of the electronic equipment (110) to be cooled, resulting in the cooling system normally having a spare cooling capacity at least equal to that of one of the cooling units (101, 102, 103). Should one of the cooling units (101, 102, 103) fail the cooling system, the remaining operable cooling units, have sufficient remaining capacity and continue to cool the electronic equipment (110), thus achieving the objective of a redundant cooling system.

In one embodiment, each of the cooling units (101, 102, 103) is essentially identical, with the same rated cooling capacity and characteristics. It is also possible and within the scope of this disclosure to configure a redundant cooling system using cooling systems with differing rated cooling capacities and characteristics, if desired.

The embodiment of FIG. 1 further contains a primary power supply (115), which is typically single or three phase AC power from the utility. For critical applications, the electronic equipment may be powered by an uninterruptible power supply (113), which in the case of telecom applications typically has a 24V DC or 48V DC output. The uninterruptible power supply typically contains a battery, or other energy storage device, which allows it to provide uninterrupted power (114) to critical equipment in the case of failure of the primary power supply. The primary power supply may further be backed up by a diesel generator (not shown), or similar, for applications requiring a high level of availability, or where the quality of primary power supply is poor.

Still referring to FIG. 1, the embodiment illustrated therein further contains a communication bus (104) which allows each unit (101, 102, 103) to share information about its operating conditions with the other cooling units (101, 102, 103) connected to the communication bus (104), as well as with other elements connected to the communications bus. The communication bus may also contain an auxiliary power supply connection, derived in a redundant way from each cooling unit, suitable for providing failsafe power to each of the control elements connected to the communication bus.

The embodiment of FIG. 1 further contains a user interface (105) connected to the communication bus (104), capable of receiving information from and providing information to other elements connected to the bus. While not being required for correct redundant operation or optimization of the efficiency or life of the cooling system, the user interface (105) can notify service personnel as to any faults in the cooling system and can aid in the fault diagnosis. This function could alternatively be provided in the controller (211) of each individual unit (101, 102, 103), or elsewhere if required. The user interface (105) also provides a convenient means for changing the setpoints of the cooling system, if desired. The alarm notification logic of the user interface can be that of active ok, whereby a fault in the user interface (105) itself is detected by the lack of a contrary indication, providing a failsafe fault indication. The embodiments disclosed herein may also be implemented with other alarm notification strategies which provide for failsafe fault indication.

The embodiment of FIG. 1 further contains an optional supplementary temperature controller (106) which is capable of compensating for errors which may occur due to temperature differences between the position or location where temperatures are detected by the cooling units (101, 102, 103) and the position or location which is being controlled, such as is observed in close proximity to the electronic equipment (110). For convenience, typical air conditioning units normally measure and control the temperature of the return air before it passes over the indoor heat exchanger in the unit. The error between the return air temperature and the temperature at the position or location under control will typically be reasonably small, but the supplementary temperature controller (106) provides a means to correct this error for those critical applications requiring higher temperature accuracy. Alternate solutions, such as extending temperature sensors from each cooling unit (101, 102, 103) to the position or location under control, could also be chosen to achieve the same result, although such alternative strategies may not be optimum from a cost and convenience standpoint. Each cooling unit (101, 102, 103) may also be configured to only accept a temperature correction value from the supplementary temperature controller (106) within a limited range, ensuring that a fault in the supplementary temperature controller (106) cannot jeopardize the operation of the overall cooling system.

The embodiment of FIG. 1 further contains an optional humidity controller (107) which is capable of measuring the humidity in the conditioned space (111). For many electronic cooling applications, controlling humidity is less critical than controlling the temperature and the cost of humidity sensors may not warrant the incorporation of humidity sensors in each unit (101, 102, 103). For applications requiring humidity control, the humidity controller (107) is used to compare the measured humidity to the desired setpoint and to provide an adjustment to the fan speeds of the indoor heat-exchanger (202) of the cooling units (101, 102, 103) thus increasing or reducing their latent cooling capacity and hence controlling the humidity of the conditioned space (111). Each cooling unit (101, 102, 103) may be configured to only accepts a fan adjustment value from the humidity controller (107) within a limited range, ensuring that a fault in the humidity controller (107) cannot jeopardize the operation of the overall cooling system.

Although the user interface (105), supplementary temperature controller (106) and humidity controller (107) have been shown and described separately for the sake of clarity, these elements may typically be combined into one physical unit for cost optimization.

The embodiment of FIG. 1 may further include optional power converter units (121, 122, 123), where the number of power converter units (121, 122, 123) typically corresponds to that of the number of cooling units (101, 102, 103). The power converter units may have two power inputs, one suitable for connection to the primary power supply (115) and one suitable for connection to the uninterruptible power supply (114). The power converter unit may be configured to connect the cooling unit to the primary power supply when the primary power supply meets specified conditions, or to the uninterruptible power supply when the primary power supply exceeds specified conditions. Operation in this way may be beneficial in terms of overall efficiency as the uninterruptible power supply (113) does not process the cooling unit power when primary power meets specified conditions, saving on these power conversion losses. The power converter unit may further contain power conversion circuitry, which may convert the uninterruptible or primary power to that suitable for powering the cooling unit, if such conversion is necessary, such as a DC/AC inverter, DC/DC converter, AC/DC converter, or similar.

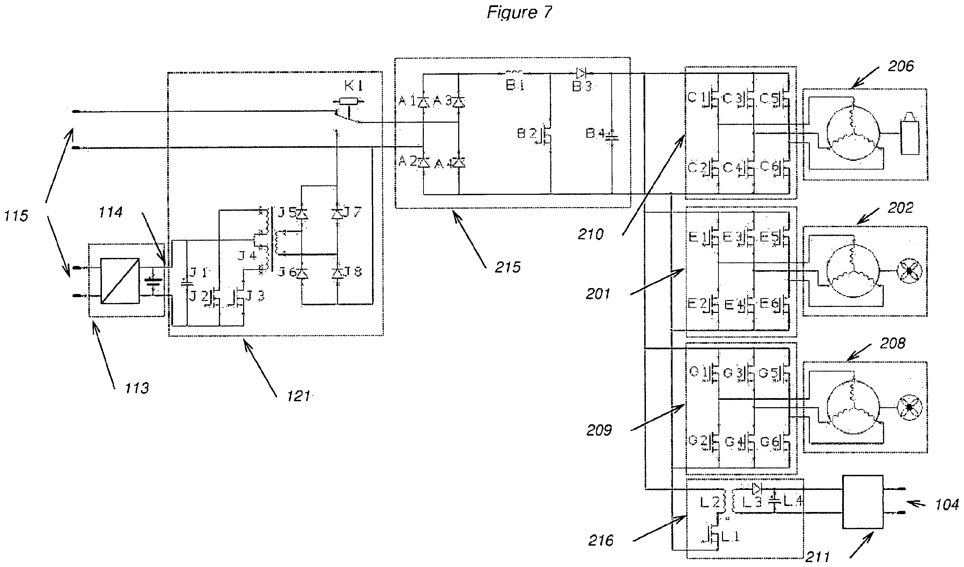

The power converter units (121, 122, 123), described above, may not be needed for the correct operation of the redundant cooling system if, for example, the quality of the primary power supply is of an acceptable level, or if the primary power supply is backed up by a diesel generator, or in other cases. The power converter units may, however, be used to improve the availability of the cooling system for cases where the quality of the primary power supply is not of an acceptable level, or where backup diesel generator operation is not desired, for example. These power converter units (121, 122, 123) are shown separately from the cooling units as this functionality may not be needed in all cases, however all or part of the power converter unit may be incorporated into the cooling unit or elsewhere if desired, the system illustrated in FIG. 7, described in more detail below, provides an example of a suitable circuit for use in the power converter unit.

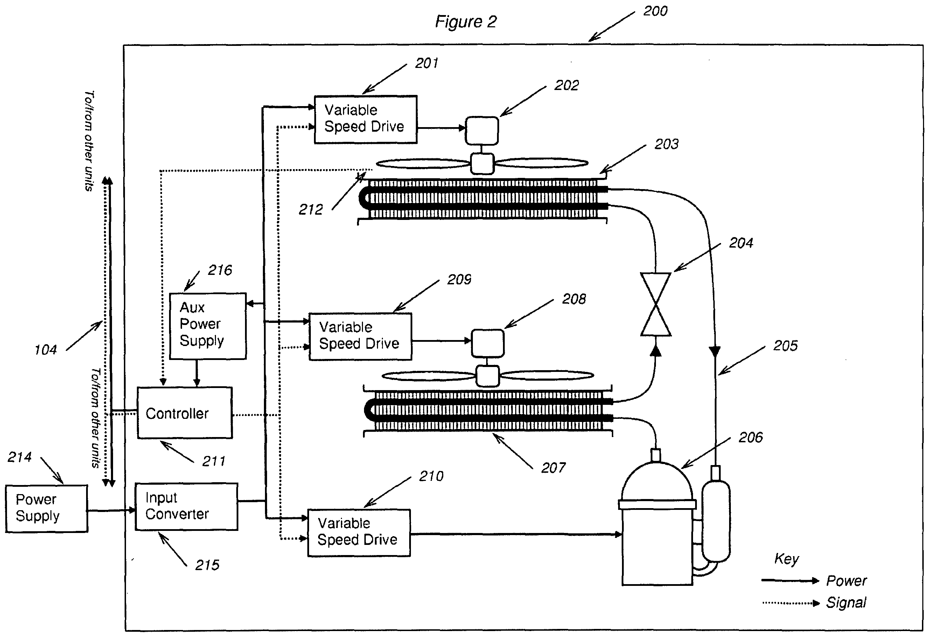

Now referring to FIG. 2, each of the aforementioned air-cooling units (101, 102, 103) is further equipped with a variable refrigerant flow system. Variable refrigerant flow systems have the benefit of improved efficiency at certain part load conditions, allowing overall system efficiency to be optimized by operating each cooling unit at a suitable operating point. The embodiment of FIG. 2 incorporates a motor driven compressor (206) controlled by a variable speed drive (210) in order to achieve the variable refrigerant flow, but this aspect of the FIG. 2 embodiment is not limiting upon the scope of the various embodiments disclosed herein. This disclosure also encompasses redundant cooling systems constructed using cooling units incorporating other variable refrigerant flow systems such as digital scroll compressors, multiple stage compressors, two- speed compressors and other cooling units which can provide improved efficiency when operated at part load conditions. The compressor further may, but is not required to be driven via DC brushless motor or permanent magnet synchronous motor (PMSM) for high efficiency, although compressors driven at variable speed via induction motors or other types of motors can also be used with beneficial results.

Each air-cooling unit (101, 102, 103) may further include a plurality of heat exchangers, whereby at least one heat exchanger is configured as an indoor heat exchanger (203) for absorbing heat from the heat generating equipment and at least one heat exchanger is configured as an outdoor heat exchanger (207) for rejecting heat to a heat sink, for example the outside air. Each air-cooling unit (101, 102, 103) may also include at least one controller (211) for controlling and operating each air cooling unit and at least one temperature sensor (212) for measuring the temperature of the conditioned space. Each heat-exchanger may further be equipped with at least one motor driven fan (202, 208) to enhance the efficiency of the heat-exchanging process. In one embodiment the speed of the indoor fan (202) is controlled by a variable speed drive (201), both enabling humidity control, as earlier described, and a beneficial reduction in power consumption at part load conditions. Similarly, in this embodiment, the speed of the outdoor fan (208) may be controlled by a variable speed drive (210) enabling a beneficial reduction in power consumption at part load conditions and the ability for the cooling unit to operate at low ambient conditions. The fans further may, but are not required to be driven via DC brushless motor or permanent magnet synchronous motor (PMSM) for high efficiency, although fans driven at variable speed via induction motors or other types of motors can also be used with beneficial results.

Each air-cooling unit (101, 102, 103) may further contain an expansion device (204) for metering the refrigerant flow. In one embodiment an electronic expansion valve (EEV) is used as the expansion device (204) due to its ability to provide close to optimum performance at a number of different operating conditions, but other expansion devices such as capillary tubes, thermostatic expansion valves (TXV) and the like can also be used.

Each air-cooling unit (101, 102, 103) may further contain an input converter (215) which is used to convert the power supply (214), connected to the cooling unit, to those suitable for inputs to the variable speed drives (201, 209, 210). This may be required, for example, in cases where the power supply (214) is AC and where the variable speed drives (201, 209, 210) require DC input for operation. The input converter (215) may further provide input current and DC bus voltage control for applications requiring this functionality. An example of an input converter is shown in more detail in FIG. 7 described below. Each cooling unit may further contain an auxiliary power supply (216) suitable for powering the at least one controller (211). The outputs of the auxiliary power supplies (216) in each air-cooling unit may also be connected in a failsafe, redundant manner (for example current limited and diode protected) via the communication bus (104) in order to provide redundant power to the various control elements connected to the bus.

FIG. 7 illustrates one example of a power circuit suitable for powering the elements of the described embodiment for cases where the primary power supply (115) is AC and the uninterruptible power supply (113) is DC, such as may be typical for telecom applications. The input converter (215) is constructed such that is can operate both from AC and DC power supplies of a similar voltage level, controlling the input current to be near sinusoidal and in phase with the input voltage when operating from AC and minimizing the low frequency AC component of the input current when operating from DC, both while controlling the average DC bus voltage across capacitor B4 to a selected level. The bridge rectifier (A1-A4) and boost converter (B1-B4) provide this functionality in the illustrated embodiment.

Telecom applications generally require equipment connected to the output of the DC uninterruptible power supply (113) to meet strict criteria, amongst them isolation from AC mains, minimized level of low frequency AC ripple current and low EMC emissions. The nominal DC voltage of a telecom DC uninterruptible power supply is typically 24V or 48V, which is usually incompatible with an input converter (215) constructed to operate from a nominal 208-240V RMS or 90-115V RMS primary supply.

The power converter unit (121) may contain a transformer (J4) with a turns ratio selected to convert the DC uninterruptible power supply voltage level to a level suitable for input to the input converter (215) and which may provide the required galvanic isolation from AC mains. Semiconductor switches J2 and J3 are switched alternately, typically at high frequency to minimize the transformer (J4) size and cost and beneficially at a fixed almost 50% duty cycle to improve the efficiency and to minimize the high frequency ripple current through capacitor (J1), reducing the amount of filtering required in order to meet EMC requirements. As the input converter (215) controls its input current (i.e. the output current of the power converter unit) to minimize the low frequency AC content and the power converter (J1-J8) is operated at a fixed duty cycle, the low frequency AC content of the input current to the power converter unit is also minimized. The output voltage of the power converter (J1-J8) generally need not be tightly regulated as the input converter (215) can typically operate over a sufficient range of input voltage, further simplifying the power converter and allowing it to operate at a fixed duty cycle.

Changeover relay (K1) may be operated such that the input converter (215) is connected to the primary power supply (115) when it meets specified conditions and to the output of the power converter (J1-J8) when the primary power supply exceeds specified conditions, such that the air-cooling unit is ordinarily supplied at high efficiency from the primary power supply (115) when it is available and from the uninterruptible power supply (113) if the primary power supply fails.

A variable speed drive (210) may be constructed using semiconductor switches (C1-C6) connected to the DC output of the input converter (215) and by controlling the switches (C1-C6) such that an AC voltage of variable amplitude and frequency is produced to control the speed of the compressor motor and compressor (206). Similarly, variable speed drives (210 and 209) can be constructed using semiconductor switches and controlled such that AC voltages of variable amplitudes and frequencies are produced in order to control the indoor and outdoor fan motors and fans (202, 208) respectively. As the input converter (215) is powered uninterruptedly, so too will the compressor and fans be powered uninterruptedly.

An auxiliary power supply (216) may also be connected to the output of the input converter (215) and hence also powered uninterruptedly. In the illustrated embodiment, the auxiliary power supply is a flyback DC/DC converter constructed using semiconductor switch (LI), coupled inductor (L2), output rectifier L3 and output capacitor (L4) although other power supply topologies could provide similar functionality. Power from the auxiliary power supply may be used to power the at least one controller (211) and may also be connected via a suitable current limiting and diode protected circuit to provide redundant, uninterrupted power to the control elements connected to the communication bus.

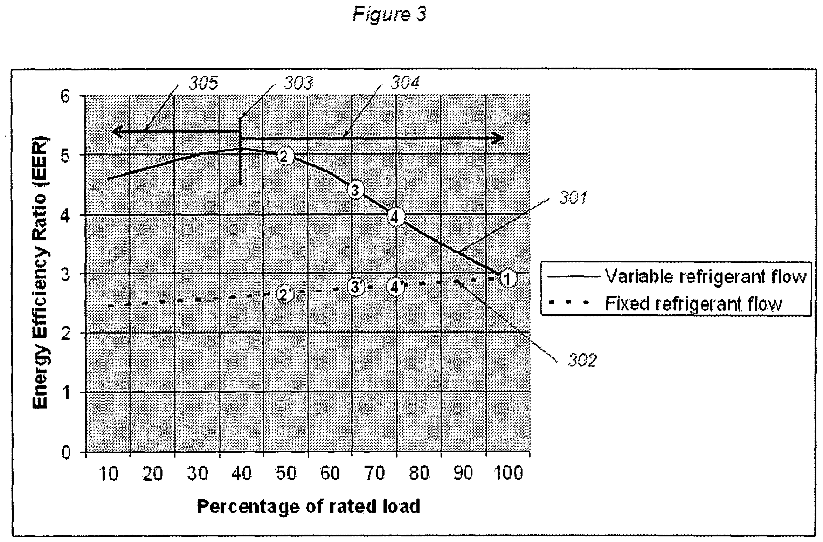

The various embodiments described above may be operated under selected conditions to enhance the energy efficiency of the overall system. FIG. 3 illustrates a typical relationship (301) between the energy efficiency ratio (EER) and the percentage of rated load for a variable refrigerant flow cooling unit equipped with variable speed compressor control, in accordance with the various embodiments disclosed herein. The characteristics differ somewhat dependent on the construction of the variable refrigerant flow cooling unit, but the general characteristics are that the energy efficiency ratio of a variable refrigerant flow cooling system increases as the percentage of rated load is decreased from rated capacity (region indicated by arrow 304), reaches a maximum (303) and then declines (region indicated by arrow 305) as losses from control circuitry, power conversion and the like exceed the efficiency gains made by operating the unit at part load conditions. Generally the percentage of rated load at which the energy efficiency ratio for a variable refrigerant flow cooling unit is the maximum is below 50% of rated load and is typically in the range of 10% - 40% of rated load. For a variable speed compressor cooling unit there is typically also a minimum speed at which the compressor can be controlled in order to regulate the cooling unit's capacity - below this minimum speed, capacity regulation needs to be accomplished by switching the compressor on and off at a suitable rate such that the unit's average cooling capacity, rather than instantaneous cooling capacity, is regulated.

For a redundant cooling system which includes a number (N) of essentially identical variable refrigerant cooling units (200) in the embodiment illustrated in FIG. 2, the operation of the redundant cooling system may be considered to be divided into two regions. The first region is where the average load per cooling unit (i.e. the total cooling load divided by the number of cooling units, N) is greater than the percentage of load at which the maximum energy efficiency ratio for the cooling unit occurs (the region indicated by the arrow 304 in FIG. 3). In the disclosed embodiments, operation in this region is termed "Linear" mode of operation. The second region is where the average load per cooling unit is less than the percentage of load at which the maximum energy efficiency ratio for the cooling unit occurs (the region indicated by the arrow 305 in FIG. 3). In the disclosed embodiments, operation in this region is termed "On/Off mode of operation.

A model of the energy efficiency ratio vs. percentage of rated load for the cooling unit (101, 102, 103) is determined based on the design of the cooling unit and by measuring the characteristics of the cooling unit (101, 102, 103). This model may then be embedded into the controllers (211) in each unit (101, 102, 103) and used to determine whether the average load per unit falls within the first or second region described above and accordingly which mode of operation (i.e. Linear or On/Off) to follow in order to minimize overall cooling system energy consumption, while regulating the temperature of the conditioned space.

For operation in the first region described above (i.e. where the average load per cooling unit is greater than that at which the maximum energy efficiency ratio for the cooling unit occurs), the highest overall cooling system efficiency can be achieved by operating each cooling unit (101, 102, 103) at the point equal to the average load per cooling unit. In other words, for highest overall cooling system efficiency, the total cooling load should be divided equally by all cooling units. This is in contrast to the lead-lag control method, where ordinarily at least one unit is kept in standby (and thus at no load conditions), and the active units are loaded at up to 100% rated load conditions.

As it is neither simple nor inexpensive to measure the total heat load and thereby calculate the required average cooling capacity per unit, it is desirable to have a control method which is able to equalize the cooling capacity per cooling unit while controlling the temperature in the conditioned space at the desired setpoint, without measuring the total cooling load. At steady state conditions (i.e. when the cooling capacity per cooling unit has been equalized and the temperature of the conditioned space has stabilized at the desired setpoint), each cooling unit will then be operating at the point equal to the required average capacity per cooling unit, as needed for simultaneous temperature control and minimum energy consumption.

For a cooling unit equipped with a variable speed compressor, the cooling capacity of the unit is approximately proportional to the compressor speed. Therefore, controlling the compressor speed in each essentially identical cooling unit to be close to or equal to that of the compressors of the other essentially identical cooling units included in the redundant cooling system, will effectively ensure that each cooling unit is close to equally loaded. The near equalized compressor speeds can in turn be controlled to regulate the temperature of the conditioned space, providing simultaneous temperature control and relatively close to minimum energy consumption.

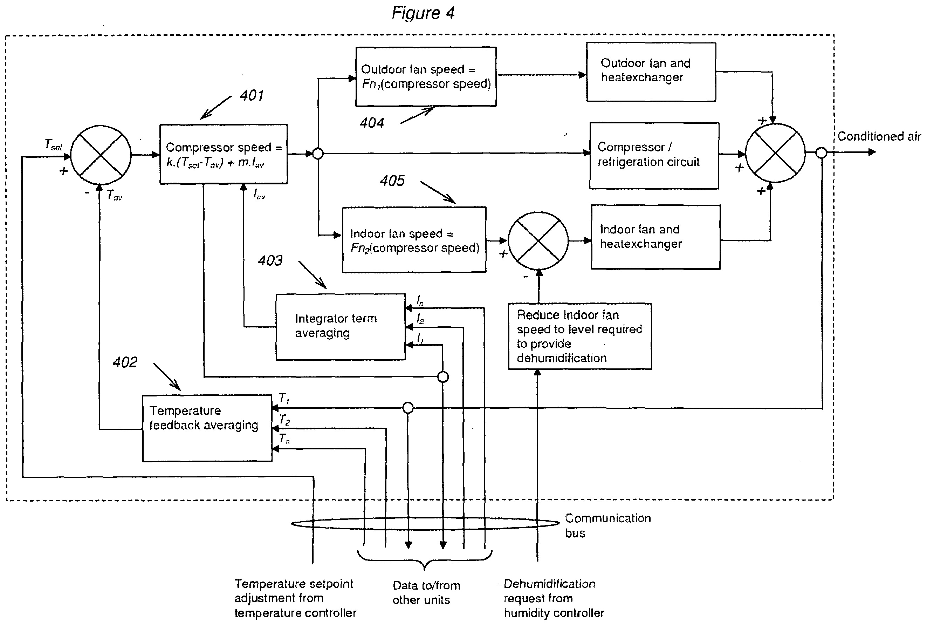

FIG. 4 illustrates a block diagram of a controller suitable for controlling each cooling unit comprising the redundant cooling system, as depicted by element 211 in FIG. 2 in the "Linear" mode of operation. The primary function of the cooling unit, and hence cooling unit controller, is to maintain the temperature in the conditioned space at the setpoint temperature for correct operation of the equipment to be cooled. A secondary function of the controller is to minimize the energy consumption of the individual cooling unit (101, 102, 103) at any particular operating point by controlling the compressor and fan speeds such that the required cooling output is provided with the minimum input power consumption. Another further function of the controller is, in conjunction with the controllers in the other cooling units comprising the redundant cooling system, to minimize the overall redundant cooling system energy consumption.

A proportional integral (PI) element (401) in the controller may be used to control the compressor speed proportional to the difference between the desired temperature (Tₛₑₜ) and the average measured feedback temperature (Tₐᵥ). The integral term in the PI element (401) cancels out any errors between the desired temperature (Tₛₑₜ) and average measured feedback temperature (Tₐᵥ), which typically occurs when purely proportional control is used. Other feedback based control methodologies can be used to implement the controller as well.

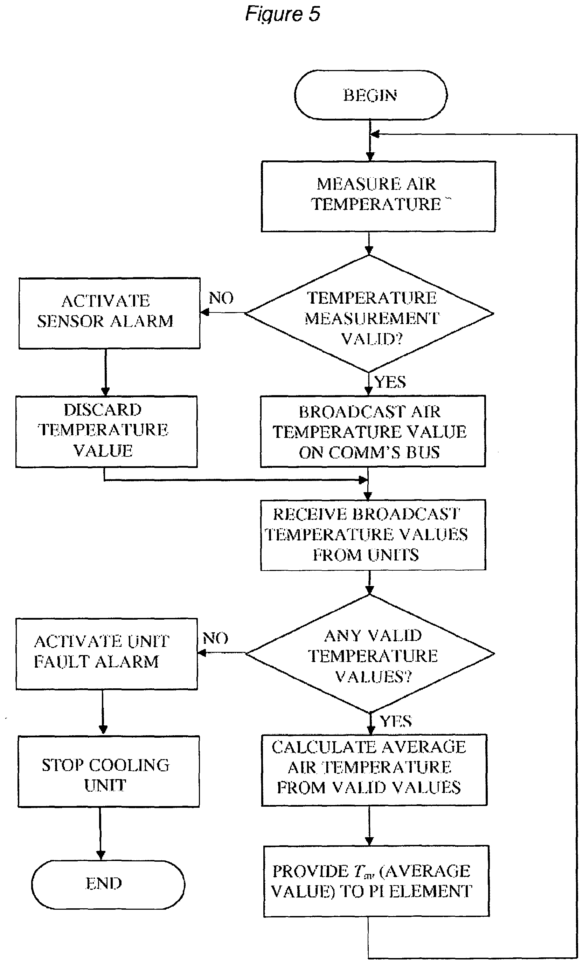

Each controller further contains a temperature feedback averaging element (402) which calculates the average temperature (Tₐᵥ) based on the temperatures (T₁, T₂, Tₙ) measured by each of the cooling units and communicated via the Communication bus (213). As the temperature feedback averaging element (402) in each controller averages the same set of measured temperatures (T₁, T₂, Tₙ), each calculates the same value for Tₐᵥ, ensuring that the same feedback temperature value is used for calculating the compressor speed in the PI element (401) of each of the units. This function ensures that temperature sensor tolerances between each unit are averaged out. Limits may be implemented on acceptable temperature range from the temperature sensor in each cooling unit, ensuring that a value from a faulty temperature sensor is excluded from the averaging calculation, protecting the redundant cooling system integrity. A faulty temperature sensor may be configured to generate an alarm to prompt for repair from service personnel. Fig. 5 is a flow chart showing one example of a suitable algorithm for implementing this failsafe functionality.

Each controller further contains an integrator term averaging element (403) which calculates the average integral term (Iₐᵥ) based on the temperatures (I₁, I₂, Iₙ) determined by each of the cooling units and communicated via the Communication bus (213). As the integrator term averaging element (403) in each controller averages the same set of Integral terms (I₁, I₂, Iₙ), each calculates the same value for Iₐᵥ, ensuring that the same integral term value is used for calculating the compressor speed in the PI element (401) of each of the units. This function ensures that any differences between the integral terms between the units, such as caused by power being applied to the units at different times, are averaged out.

It shall be apparent from the above description that, as the parameters used as the input to the PI element (401) in the controller of each cooling unit are the same, the PI element (401) in the controller of each cooling unit will determine about the same compressor speed for each cooling unit, thus about equalizing the compressor speeds in each cooling unit included in the redundant cooling system and meeting the objective of near minimum overall energy consumption as earlier detailed.

It shall further be apparent that in the case of failure of the communication bus, each cooling unit is still able to control the temperature of the conditioned space independently, hence maintaining the redundant system integrity, albeit with the loss of the energy minimization function. A fault in the communication bus may be configured to generate an alarm to prompt for repair from service personnel.

In addition to the temperature control and compressor speed equalization functions described above, each controller may further contains fan speed control elements (404 and 405) to control the outdoor and indoor heat exchanger fan speeds (208 and 202 in FIG. 2) to minimize the power consumption of each unit at part load conditions. As the power consumed by a fan is proportional to the cube of the speed, substantial savings in fan power consumption can be achieved by operating a fan at a reduced speed. However, the reduced fan speed results in airflow over the heat exchanger being reduced proportionally to the fan speed, which in turn results in more compressor power being required to meet the same cooling requirements. At a certain range of part load conditions, the power savings achieved from operating fans at reduced speed may outweigh the compensating increase in compressor power resulting in a higher energy efficiency for the cooling unit for that certain range of part load conditions.

Based on the determined model for the cooling unit, the controller may be configured to implement functions to vary the indoor and outdoor fan speeds dependent on the cooling load on the unit, in order to minimize the energy consumption of the cooling unit at the particular load condition. As mentioned earlier, the cooling capacity is approximately proportional to the compressor speed, so the compressor speed may be selected as a suitable parameter from which to determine the optimum indoor and outdoor fan speeds. As the system will adjust the compressor speeds to be equal to each other, and the indoor and outdoor fan speeds in each cooling unit may be controlled as a function of the compressor speed, fan speeds between the cooling units will also be approximately equalized.

The foregoing describes a suitable control method for use during the "Linear" mode of operation, element 304 of FIG. 3, where the required average output per cooling unit is higher than that at which the maximum energy efficiency ratio for the cooling unit occurs. In other cases, the required average output per cooling unit may be selected to be, or happen to be, below that at which the maximum energy efficiency ratio of the cooling unit occurs, i.e. the range of loads indicated by 305 in FIG. 3. This may occur, for example, where the redundant cooling system is over dimensioned to allow for an expansion in the heat generating equipment capacity, or in other situations. In this case it may be more desirable, from an energy efficiency standpoint, to operate individual cooling units at the point at which the maximum energy efficiency ratio occurs (element 303 in FIG. 3).

In the over dimensioned or similar situation described immediately above, if each individual cooling unit is operated at a cooling output higher than the average output required to meet the total cooling requirements, the total cooling output of the redundant cooling system will be greater than that required to match the total cooling requirements and the temperature of the conditioned space will be reduced. However, by switching off a sufficient number of the individual cooling units and operating the remaining units at the operating point at which their maximum energy efficiency ratio occurs, the total cooling output of the redundant cooling system can be reduced to below that required to match the total cooling requirements and the temperature of the conditioned space will be increased. So by suitably switching individual cooling units alternatively off or on, at the point at which their maximum energy efficiency ratio occurs, it is possible to control the average temperature of the conditioned space equal to the desired setpoint in the on/off mode of operation, element 305 of FIG. 3.

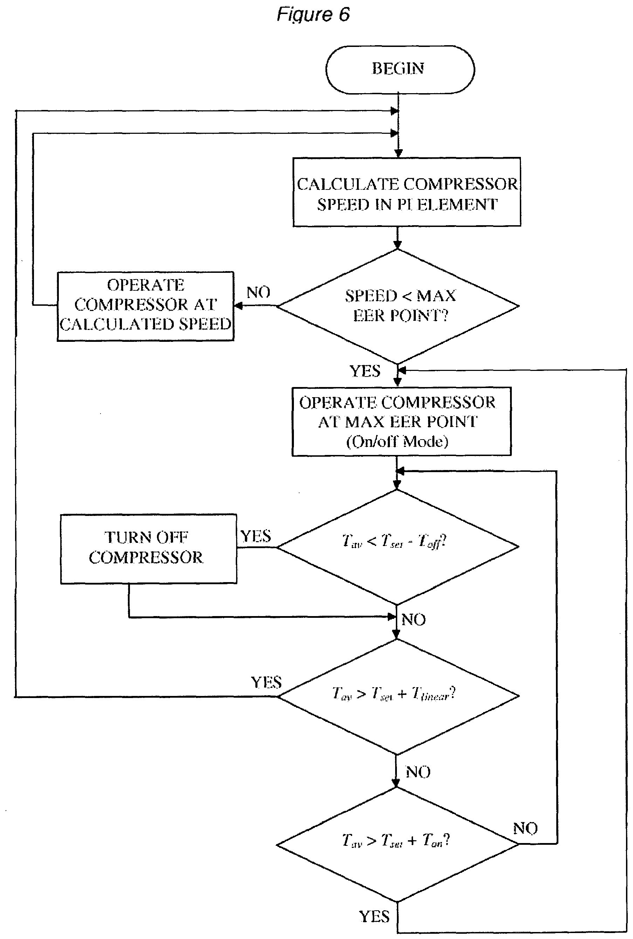

FIG. 6 is a flow chart detailing a suitable algorithm for controlling individual cooling unit operation, switching between "Linear" mode of operation304 and "On/off' mode of operation 305 as previously defined. This or a similar algorithm may be embedded into the controller (211 in FIG. 2) in each cooling unit. Each unit starts operation in Linear mode, whereby the PI element (401) in each controller adjusts the compressor speed based on the difference between the average measured temperature (*Tₐᵥ*) and the setpoint temperature (*Tₛₑₜ*), while simultaneously equalizing the compressor speeds between the cooling units as earlier described. If the total cooling output of all the cooling units included within the redundant cooling system, is greater than the required cooling, the temperature of the conditioned space will reduce. This will in turn cause the PI element (401) in each controller to adjust the compressor speed until the total cooling output of all units included within the redundant cooling system is equal to the required cooling and the measured temperature (*Tₐᵥ*) of the conditioned space will be stabilized at the setpoint (*Tₛₑₜ*). Should the calculated compressor speed (which is about the same in each cooling unit) be lower than that at which the embedded model determines the maximum energy efficiency ratio for the unit occurs, the unit may be configured to change to an On/Off mode of operation. Similarly the other units, with their equalized compressors speeds, will also change to an On/Off mode of operation at about the same time.

In On/Off mode of operation, each controller checks if the average measured temperature (*Tₐᵥ*) drops below the setpoint (*Tₛₑₜ*) by more than a predetermined amount (T*_{off}*). If so, the compressor in the unit is turned off. In this implementation, the controllers in all cooling units determine the same *Tₐᵥ* and have the same setpoint (*Tₛₑₜ*) and *T_{off}*, so will all make the same decision to turn their compressors off. Each unit's fan speeds are controlled as a function of the compressor speed in order to maximize energy efficiency for the unit - when the compressor speed is set to zero, the indoor and outdoor fan speeds may also be set to zero to minimize the unit's energy consumption, reducing each unit's power consumption close to zero.

When the cooling unit's compressors are turned off, cooling output is reduced to zero causing the temperature in the conditioned space to rise. Each controller checks if the average measured temperature (*Tₐᵥ*) rises above the setpoint (*Tₛₑₜ*) by more than a predetermined amount (*Tₒₙ*). If so, the compressor in the unit is turned on. In this implementation, the controllers in all cooling units determine the same *Tₐᵥ* and have the same setpoint (*Tₛₑₜ*) and *Tₒₙ*, so will all make the same decision to turn their compressors on at about the same time. If the average measured temperature (*Tₐᵥ*) continues to increase once all the units are operating their compressors at the maximum EER point, this indicates that the total cooling load is larger than the total cooling output of all units operating at their maximum EER point - indicating that the linear mode of operation should be used for control. If the average measured temperature (*Tₐᵥ*) reaches the higher threshold point (*Tₗᵢₙₑₐᵣ*) above the setpoint (*Tₛₑₜ*), each unit reverts to linear mode of operation.

In some cases it may be desirable to switch the individual cooling units on and off in stages in on/off mode of operation, rather than have all cooling units switch on simultaneously and switch off simultaneously. This may, for example, allow for the control of the temperature within a narrower on/off band without excessive cycling of the individual cooling units. This can be accomplished by switching cooling units off, one at a time with a sufficient length of time between successive cooling units being switched off to check if the temperature of the conditioned space is rising and thus that the total cooling output is less than the required cooling output. Similarly cooling units may be switched back on, one at a time, with a sufficient length of time between successive cooling units being switched on to check if the temperature of the conditioned space is dropping and thus that the total cooling output is more than the required cooling output. The communication bus can be utilized to rotate the operation of the cooling units, and ensure that units experience even wear.

The foregoing description has focused mainly on the objective of minimizing the energy consumption of the disclosed redundant cooling system by distributing the cooling load equally across all cooling units. It shall be apparent, to one skilled in the art, that one of the causes of reduced life of components is the temperature at which the components are operated. In accordance with the Arrhenius equation, a 10C increase in temperature results in approximately a 50% reduction in MTBF. Accordingly it is advantageous from a reliability point of view to operate key components at a low temperature.

Certain components in the cooling unit are subjected to heating due to electrical and mechanical losses which occur during operation. As the embodiments disclosed herein improve the efficiency of the redundant cooling system compared to a typical lead/lag control system, the overall losses in the described invention are reduced. Lower losses imply less heating of the components and corresponding improved MTBF. Is shall also be apparent that, during the linear mode of operation, the losses are divided equally among all the cooling units comprising the redundant cooling system, as compared to the lead/lag control system where the losses are divided between only the active units. So, during the linear mode of operation, the overall cooling system losses are reduced due to the improvement in system efficiency and the losses are divided among more cooling units than in the lead/lag control method, resulting in substantially lower losses per cooling unit.

Although the losses per cooling unit are substantially lower for the described method of control compared to a lead/lag control method, each unit is operated continuously rather than being held in standby for a proportion of the time as in the lead/lag control method. For typical system implementations and operating conditions the gains made from operating components at lower temperatures exceed the impact of the additional running time resulting in an improved system MTBF.

In some cases it may be desirable, from a cost point of view, to utilize "comfort" type cooling units as the cooling units in the redundant cooling system for cooling electronic equipment. "Comfort" type cooling units are normally manufactured in high volumes, allowing a low cost per unit to be achieved. One of the differences between "comfort" cooling units (which are designed for providing a comfortable environment for people) and "precision" cooling units (which are designed to provide a suitable environment for electronics) is that comfort cooling units have a comparatively large proportion of their total cooling capacity dedicated to latent cooling (removing humidity). The total cooling capacity of a cooling unit is defined as the sum of the sensible cooling capacity (capacity which is used for lowering the temperature of the air) and latent capacity (capacity used for reducing the humidity of the air). The sensible heat ratio (SHR) of a cooling unit is defined as the ratio of the sensible cooling capacity over the total cooling capacity of a cooling unit.

Telecom equipment (and other electronic heat generating sources) generates no humidity and the conditioned space in which the equipment is located is normally fairly well sealed from the outside atmosphere, meaning little or no humidity removal (latent cooling) is required. Excessive latent cooling causes the humidity in the conditioned space to be reduced below the desired level and is not energy efficient. Comfort cooling units are generally designed to have a sensible heat ratio (SHR) of around 60 to 80% at rated conditions, whereas a precision cooling unit is generally designed to have a SHR of around 90 to 100% at rated conditions. Comfort cooling units are therefore ordinarily not ideal for use in electronic equipment cooling applications.

The SHR of a cooling unit is a function of the total cooling capacity of the unit and the volume of airflow across the indoor heat exchanger. The maximum airflow across the indoor heat exchanger of a comfort cooling unit is generally limited by the fan and motor around which the unit is designed, so can generally not be easily changed to increase the airflow and thus increase the SHR of the unit. However, by operating the cooling unit at a reduced cooling output and maintaining a proportionately higher airflow, it is possible to increase the SHR of the cooling unit. In the linear and on/off modes of operation as earlier described, each cooling unit is ordinarily operated at less than maximum cooling output conditions, allowing the SHR of each cooling unit to be increased by maintaining a proportionately higher airflow volume across the indoor heat exchanger of the cooling unit. In one embodiment this may be implemented into the function which controls the indoor fan speed dependent on the compressor speed in the controller of each cooling unit.

In the case of a failure of one cooling unit, each of the remaining units may become loaded up to their maximum rated cooling capacity. In this case the SHR of each cooling unit and likewise the overall redundant cooling system will be reduced back to that of each of the cooling units at rated capacity. In the case of comfort cooling units being used as the cooling units comprising the redundant cooling system, the resultant SHR will be below the optimum value for cooling electronics, which can cause the humidity to be reduced below the desired value and the efficiency of the cooling system to be affected. The temperature of the conditioned space may also increase from the setpoint as the sensible heat load may exceed the sensible cooling capacity of the remaining cooling units. However, the failure of a cooling unit may be configured to notify service personnel for prompt action and, depending on the application, the lower than desired humidity and efficiency and higher temperature of the conditioned space may be acceptable for a short time period.

As mentioned, cooling systems for electronic applications do not generally need to provide dehumidification (latent cooling) as electronic equipment does not generate humidity. However for cases where the conditioned space is not well isolated from the external environment, it may be necessary to provide dehumidification to maintain the humidity of the conditioned space at the desired level.

In order for the cooling units to provide dehumidification, the indoor heat exchangers need to be at a temperature below the dew point of the air passing over the heat exchanger. In one embodiment this is accomplished by reducing the speed of the fan of the indoor heat exchanger, thus reducing the airflow over the indoor heat exchanger. This in turn causes a compensating reduction in the indoor heat exchanger temperature in order to maintain the return air temperature at the setpoint. By a suitable reduction of the indoor fan speed, the desired amount of dehumidification results.

In one embodiment, a humidity controller (107 in FIG. 1) monitors the humidity of the conditioned space. If the humidity exceeds the humidity setpoint by a defined amount, the humidity controller notifies all cooling units via the communication bus that dehumidification is required.

The cooling units accordingly reduce their indoor fan speeds such that they provide dehumidification. Once the humidity has dropped below the humidity setpoint by a defined amount the humidity controller notifies all cooling units via the communication bus that dehumidification is no longer required, whereupon all cooling units adjust their indoor fan speeds back to the level which results in the best efficiency for the cooling unit. The system may incorporate an alarm which is activated if dehumidification is required for longer than a predetermined length of time, indicating a potential problem with the system, or that the conditioned space is not well sealed. Cooling units also may incorporate a protection feature whereby dehumidification is cancelled if the temperature of the conditioned space rises above a predetermined level, protecting against faults in the humidity controller. In an alternative embodiment for controlling the humidity, only one of the cooling units may be selected to reduce its indoor fan speed to perform dehumidification, with the remaining units maintaining their fan speeds at the level which results in the best efficiency for the respective cooling unit. This alternative embodiment may take longer to perform the required dehumidification, but may result in lower overall energy consumption. This alternative embodiment may further include a feature whereby the dehumidifying unit is rotated among the cooling units in order to equalize wear on the cooling units.

In the embodiments disclosed above, a model of the cooling unit is used to determine the optimum operating point for each unit. In an alternative embodiment, a closed loop approach may be followed, whereby the power consumption of each cooling unit (101, 102, 103) is measured and the total power consumption minimized by adjusting the operating point of each cooling unit (101, 102, 103) accordingly. The closed loop approach still requires a reasonably accurate model of the cooling unit and requires additional transducers to measure the input power of each cooling unit. Often, the extra cost and complexity of such a system does not justify the gains in performance if compared to a sufficiently well modeled unit using the open loop approach described above.

In an open loop embodiment described above, each cooling unit controls the temperature of the conditioned space to the set point independently and a communications bus is used for sharing information to allow the units to equalize their compressor speeds and provide status information. In an alternative open loop embodiment, each cooling unit is constructed such that its compressor speed is proportional to the difference between the measured temperature and the setpoint temperature. As the temperature of the conditioned space measured by each unit will be close to that measured by all the other units, the compressor speeds in each cooling unit will be close to the same, without requiring any connection or communication between the cooling units. However, there will be a resultant steady state error between the set point temperature and the measured temperature of the conditioned space.

If the heat load in the conditioned space is relatively constant and a certain error between the setpoint and actual temperature is acceptable, this can be manually compensated for by adjusting the temperature setpoints in the cooling units. Alternatively an external temperature controller can measure the temperature of the conditioned space and adjust the setpoints of the cooling units to compensate for this resultant steady state error; however this controller will require a connection to each cooling unit in order to adjust the setpoints. It is likely that a simpler and lower cost connection (such as an analogue signal) can be used to adjust the setpoint temperature of this alternative embodiment rather than the communication bus described above. However, less control and status information to/from each unit is possible with a simple connection than is available when utilizing a communication bus, thus making fault finding, diagnostics and adjustments more complicated when a simple connection is used. Also, compressor speeds will not be as well equalized as in the open loop embodiment featuring a communication bus as described above, due to tolerances in temperature sensors and differences in positions where the temperature of the conditioned space is measured.

As described above, the various embodiments are, optimized for use with heat generating equipment which require air cooling for the removal of excess heat. A redundant cooling system can also be constructed in a similar manner and with similar benefits and features to those described for use with heat generating equipment which requires liquid cooling for the removal of heat. In this case the indoor air to liquid heat exchangers and fans of the individual cooling units could be replaced by liquid to liquid heat exchangers, or the refrigerant from each cooling unit could be directly circulated through a heat exchanger or heat exchangers in the heat generating equipment, if the heat generating equipment is suitably designed.

Various embodiments of the disclosure could also include permutations of the various elements recited in the claims as if each dependent claim was a multiple dependent claim incorporating the limitations of each of the preceding dependent claims as well as the independent claims. Such permutations are expressly within the scope of this disclosure.

While the invention has been particularly shown and described with reference to a number of embodiments, it would be understood by those skilled in the art that changes in the form and details may be made to the various embodiments disclosed herein without departing from the spirit and scope of the invention and that the various embodiments disclosed herein are not intended to act as limitations on the scope of the claims. All references cited herein are incorporated in their entirety by reference.

## Claims

1. A method of implementing a redundant cooling system for providing a predetermined maximum cooling load for air in a conditioned space (111), the method comprising:
providing a plurality of variable refrigerant flow air cooling units (101, 102, 103) comprising a variable speed compressor, wherein the number of air cooling units (101, 102, 103) is at least one more than required to meet the predetermined maximum cooling load when operating the air cooling units (101, 102, 103) at up to a maximum cooling capacity;
coupling the plurality of variable refrigerant flow air cooling units (101, 102, 103) in thermal communication with the air in the conditioned space (111); and
determining a select optimum operating condition for each of the plurality of variable refrigerant flow air cooling units (101, 102, 103) which will result in a lowest overall energy consumption for the redundant cooling system, while maintaining an average temperature of the air in the conditioned space (111) at a required setpoint; and
a) operating the variable speed compressors of each of the plurality of refrigerant flow air cooling units (101, 102, 103) at approximately the same speed when the cooling output of each cooling unit (101, 102, 103) is above that at which a maximum energy efficiency ratio of the unit occurs; and
b) at least one of i) turning off the variable speed compressors of one or more of the plurality of air cooling units (101, 102, 103) when the average required cooling output of all of the plurality of air cooling units (101, 102, 103) is below that at which the maximum energy efficiency ratio of the air cooling unit (101, 102, 103) occurs; and ii) operating each of the plurality of air cooling units (101, 102, 103) at about the point at which the maximum energy efficiency ratio of the air cooling unit (101, 102, 103) occurs.

2. The method of claim 1 whereby each of the variable refrigerant flow air cooling units (101, 102, 103) is associated with a controller which provides for the cooling output of the cooling unit (101, 102, 103) to be varied to control the temperature of the conditioned space (111) about equal to that of the temperature setpoint.

3. The method of claim 2 further comprising:
controlling the length of time that the compressor of each of the plurality of air cooling units (101, 102, 103) is on; and
controlling the length of time that the compressor of each of the plurality of air cooling units (101, 102, 103) is off, such that wear for the compressor of each of the air cooling units (101, 102, 103) is approximately equalized over time.

4. The method of claims 2 or 3 further comprising communicating information to determine an optimum point of operation for each cooling unit (101, 102, 103) between the controller associated with each variable refrigerant flow air cooling unit (101, 102, 103) whereby the controller associated with each unit (101, 102, 103) provides and receives information which will result in about the lowest overall energy consumption for the redundant cooling system and operates each cooling unit (101, 102, 103) at about the determined optimum operating point.

5. The method of claim 4 whereby the controller in each variable refrigerant flow air cooling unit (101, 102, 103) incorporates a communication means, and whereby the controller in each unit (101, 102, 103) provides information about the cooling unit (101, 102, 103) which allows at least one of its operating or fault status to be determined and whereby the cooling unit setpoints can be adjusted.

6. The method of any of the preceding claims whereby each variable refrigerant flow air cooling unit (101, 102, 103) incorporates a variable speed drive and associated control means, the method further comprising adjusting the speed of an indoor fan to control the latent cooling capacity of the cooling unit (101, 102, 103).

7. The method of any of the preceding claims further comprising measuring the humidity of the conditioned space (111) and adjusting the latent cooling capacity of the cooling units (101, 102, 103) to control the humidity of the conditioned space (111).

8. The method of any of the preceding claims further comprising adjusting the speed of an indoor fan associated with one or more of the plurality of variable refrigerant flow air cooling units (101, 102, 103) to approximately minimize the energy consumption of the cooling unit (101, 102, 103) at a selected cooling output.

9. The method of any of the preceding claims further comprising adjusting the speed of an outdoor fan associated with one or more of the plurality of variable refrigerant flow air cooling units (101, 102, 103) to approximately minimize the energy consumption of the cooling unit (101, 102, 103) at a selected cooling output.

10. The method of any of the preceding claims further comprising:
monitoring the status of the individual cooling units (101, 102, 103) with a communications means and the status information is used as one of the inputs for determining fault conditions; and
notifying a user or service personnel of a fault condition in the redundant cooling system.

11. The method of any of the preceding claims further comprising increasing the Sensible Heat Ratio of the system by operating one or more selected units of the plurality of variable refrigerant flow air cooling units (101, 102, 103) with an indoor airflow proportionally higher for a selected cooling output than a maximum indoor airflow at a maximum cooling output.

12. The method of any of the preceding claims further comprising increasing the MTBF of the plurality of variable refrigerant flow air cooling units (101, 102, 103) by minimizing the total losses in the system and by dividing the minimized losses evenly among all cooling units (101, 102, 103).

13. A cooling system for providing a predetermined maximum cooling load for air in a conditioned space (111), the system comprising:
a plurality of variable refrigerant flow air cooling units (101, 102, 103), wherein the number of air cooling units (101, 102, 103) is at least one more than required to meet the predetermined maximum cooling load when operating the air cooling units (101, 102, 103) at up to a maximum cooling capacity, and the plurality of variable refrigerant flow air cooling units (101, 102, 103) are coupled in thermal communication with the air in the conditioned space (111); and
means for determining a select optimum operating condition for each of the plurality of variable refrigerant flow air cooling units (101, 102, 103) which results in a lowest overall energy consumption for the redundant cooling system, while maintaining an average temperature of the air in the conditioned space (111) at a required setpoint;
the variable refrigerant flow air cooling units (101, 102, 103) comprising a variable speed compressor and wherein the variable speed compressors of each of the plurality of refrigerant flow air cooling units (101, 102, 103) are capable of operating at approximately the same speed when the cooling output of each cooling unit (101, 102, 103) is above that at which a maximum energy efficiency ratio of the unit occurs;
and the system is capable of at least one of a) turning off the variable speed compressors of one or more of the plurality of air cooling units (101, 102, 103) when the average required cooling output of all of the plurality of air cooling units (101, 102, 103) is below that at which the maximum energy efficiency ratio of the air cooling unit occurs, and b) operating each of the plurality of air cooling units (101, 102, 103) at about the point at which the maximum energy efficiency ratio of the air cooling unit occurs.

## Patentansprüche

1. Verfahren zum Implementieren eines redundanten Kühlsystems zum Bereitstellen einer vorbestimmten maximalen Kühllast für Luft in einem konditionierten Raum (111), wobei das Verfahren Folgendes umfasst:
Bereitstellen einer Vielzahl von Luftkühleinheiten (101, 102, 103) mit variablem Kältemittelfluss, die einen Verdichter mit variabler Drehzahl umfassen, wobei die Anzahl von Luftkühleinheiten (101, 102, 103) mindestens eine mehr beträgt, als zum Erfüllen der vorbestimmten maximalen Kühllast, wenn die Luftkühleinheiten (101, 102, 103) mit bis zu einer maximalen Kühlkapazität betrieben werden, erforderlich ist;
Koppeln der Vielzahl von Luftkühleinheiten (101, 102, 103) mit variablem Kältemittelfluss in thermischer Kommunikation mit der Luft im konditionierten Raum (111) und
Bestimmen eines ausgewählten optimalen Betriebszustands für jede der Vielzahl von Luftkühleinheiten (101, 102, 103) mit variablem Kältemittelfluss, der für das redundante Kühlsystem in einem niedrigsten Gesamtenergieverbrauch resultiert, während eine Durchschnittstemperatur der Luft im konditionierten Raum (111) auf einem erforderlichen Sollwert beibehalten wird; und
a) Betreiben der Verdichter mit variabler Drehzahl von jeder der Vielzahl von Kältemittelflussluftkühleinheiten (101, 102, 103) mit in etwa derselben Drehzahl, wenn die Kühlleistung jeder Kühleinheit (101, 102, 103) über jener liegt, bei der ein maximales Energieeffizienzverhältnis der Einheit eintritt; und
b) mindestens eines von i) Abschalten der Verdichter mit variabler Drehzahl von einer oder mehreren der Vielzahl von Luftkühleinheiten (101, 102, 103), wenn die durchschnittliche erforderliche Kühlleistung aller der Vielzahl von Luftkühleinheiten (101, 102, 103) unter jener liegt, bei der das maximale Energieeffizienzverhältnis der Luftkühleinheit (101, 102, 103) eintritt; und ii) Betreiben jeder der Vielzahl von Luftkühleinheiten (101, 102, 103) an ungefähr dem Punkt, an dem das maximale Energieeffizienzverhältnis der Luftkühleinheit (101, 102, 103) eintritt.

2. Verfahren nach Anspruch 1, wodurch jede der Luftkühleinheiten (101, 102, 103) mit variablem Kältemittelfluss mit einer Steuerung verknüpft ist, die es bereitstellt, dass die Kühlleistung der Kühleinheit (101, 102, 103) derart variiert wird, dass die Temperatur des konditionierten Raums (111) ungefähr mit jener des Temperatursollwerts gleich ist.

3. Verfahren nach Anspruch 2, das ferner Folgendes umfasst:
Steuern der Länge der Zeit, die der Verdichter jeder der Vielzahl von Luftkühleinheiten (101, 102, 103) eingeschaltet ist; und
Steuern der Länge der Zeit, die der Verdichter jeder der Vielzahl von Luftkühleinheiten (101, 102, 103) ausgeschaltet ist, derart, dass ein Verschleiß für den Verdichter von jeder der Luftkühleinheiten (101, 102, 103) im Laufe der Zeit in etwa ausgeglichen ist.

4. Verfahren nach Anspruch 2 oder 3, das ferner das Kommunizieren von Informationen zum Bestimmen eines optimalen Betriebspunktes für jede Kühleinheit (101, 102, 103) zwischen der Steuerung, die mit jeder Luftkühleinheit (101, 102, 103) mit variablem Kältemittelfluss verknüpft ist, wodurch die Steuerung, die mit jeder Einheit (101, 102, 103) verknüpft ist, Informationen bereitstellt und empfängt, die in ungefähr dem niedrigsten Gesamtenergieverbrauch für das redundante Kühlsystem resultiert, und jede Kühleinheit (101, 102, 103) ungefähr an dem bestimmten optimalen Betriebspunkt betreibt.

5. Verfahren nach Anspruch 4, wodurch die Steuerung in jeder Luftkühleinheit (101, 102, 103) mit variablem Kältemittelfluss ein Kommunikationsmittel beinhaltet und wodurch die Steuerung in jeder Einheit (101, 102, 103) Informationen über die Kühleinheit (101, 102, 103) bereitstellt, die es erlauben, dass mindestens einer eines Betriebs- oder eines Fehlerstatus bestimmt wird, und wodurch die Kühleinheitsollwerte angepasst werden können.

6. Verfahren nach einem der vorhergehenden Ansprüche, wodurch jede Luftkühleinheit (101, 102, 103) mit variablem Kältemittelfluss einen Antrieb mit variabler Drehzahl und ein damit verknüpftes Steuermittel beinhaltet, wobei das Verfahren ferner das Anpassen der Drehzahl eines Innenraumlüfters zum Steuern der latenten Kühlkapazität der Kühleinheit (101, 102, 103) umfasst.

7. Verfahren nach einem der vorhergehenden Ansprüche, das ferner das Messen der Feuchtigkeit des konditionierten Raums (111) und das Anpassen der latenten Kühlkapazität der Kühleinheiten (101, 102, 103), um die Feuchtigkeit des konditionierten Raums (111) zu steuern, umfasst.

8. Verfahren nach einem der vorhergehenden Ansprüche, das ferner das Anpassen der Drehzahl eines Innenraumlüfters, der mit einer oder mehreren der Vielzahl von Luftkühleinheiten (101, 102, 103) mit variablem Kältemittelfluss verknüpft ist, um den Energieverbrauch der Kühleinheit (101, 102, 103) bei einer ausgewählten Kühlleistung in etwa zu minimieren, umfasst.

9. Verfahren nach einem der vorhergehenden Ansprüche, das ferner das Anpassen der Drehzahl eines Außenraumlüfters, der mit einer oder mehreren der Vielzahl von Luftkühleinheiten (101, 102, 103) mit variablem Kältemittelfluss verknüpft ist, um den Energieverbrauch der Kühleinheit (101, 102, 103) bei einer ausgewählten Kühlleistung in etwa zu minimieren, umfasst.

10. Verfahren nach einem der vorhergehenden Ansprüche, das ferner Folgendes umfasst:
Überwachen des Status der einzelnen Kühleinheiten (101, 102, 103) mit einem Kommunikationsmittel und die Statusinformationen werden als eine der Eingaben zum Bestimmen von Fehlerzuständen verwendet und
Benachrichtigen eines Benutzers oder von Wartungspersonal über einen Fehlerzustand im redundanten Kühlsystem.

11. Verfahren nach einem der vorhergehenden Ansprüche, das ferner das Erhöhen des sensiblen Wärmeverhältnisses des Systems durch Betreiben von einer oder mehreren ausgewählten Einheiten der Vielzahl von Luftkühleinheiten (101, 102, 103) mit variablem Kältemittelfluss mit einem Innenraumluftstrom, der für die ausgewählte Kühlleistung proportional höher ist als ein maximaler Innenraumluftstrom bei einer maximalen Kühlleistung.

12. Verfahren nach einem der vorhergehenden Ansprüche, das ferner das Erhöhen der MTBF der Vielzahl von Luftkühleinheiten (101, 102, 103) mit variablem Kältemittelfluss durch Minimieren der Gesamtverluste im System und durch gleichmäßiges Aufteilen der minimierten Verluste unter allen Kühleinheiten (101, 102, 103) umfasst.

13. Kühlsystem zum Bereitstellen einer vorbestimmten maximalen Kühllast für Luft in einem konditionierten Raum (111), wobei das Kühlsystem Folgendes umfasst:
eine Vielzahl von Luftkühleinheiten (101, 102, 103) mit variablem Kältemittelfluss, wobei die Anzahl von Luftkühleinheiten (101, 102, 103) mindestens eine mehr beträgt, als zum Erfüllen der vorbestimmten maximalen Kühllast, wenn die Luftkühleinheiten (101, 102, 103) mit bis zu einer maximalen Kühlkapazität betrieben werden, erforderlich ist, und die Vielzahl von Luftkühleinheiten (101, 102, 103) mit variablem Kältemittelfluss in thermischer Kommunikation mit der Luft im konditionierten Raum (111) gekoppelt sind; und
Mittel zum Bestimmen eines ausgewählten optimalen Betriebszustands für jede der Vielzahl von Luftkühleinheiten (101, 102, 103) mit variablem Kältemittelfluss, der für das redundante Kühlsystem in einem niedrigsten Gesamtenergieverbrauch resultiert, während eine Durchschnittstemperatur der Luft im konditionierten Raum (111) auf einem erforderlichen Sollwert beibehalten wird;
wobei die Luftkühleinheiten (101, 102, 103) mit variablem Kältemittelfluss einen Verdichter mit variabler Drehzahl umfassen und wobei die Verdichter mit variabler Drehzahl von jeder der Vielzahl von Kältemittelflussluftkühleinheiten (101, 102, 103) in der Lage sind, mit in etwa derselben Drehzahl betrieben zu werden, wenn die Kühlleistung jeder Kühleinheit (101, 102, 103) über jener liegt, bei der ein maximales Energieeffizienzverhältnis der Einheit eintritt;
und das System zu mindestens einem von a) Abschalten der Verdichter mit variabler Drehzahl von einer oder mehreren der Vielzahl von Luftkühleinheiten (101, 102, 103), wenn die durchschnittliche erforderliche Kühlleistung aller der Vielzahl von Luftkühleinheiten (101, 102, 103) unter jener liegt, bei der das maximale Energieeffizienzverhältnis der Luftkühleinheit eintritt; und b) Betreiben jeder der Vielzahl von Luftkühleinheiten (101, 102, 103) an ungefähr dem Punkt, an dem das maximale Energieeffizienzverhältnis der Luftkühleinheit eintritt, in der Lage ist.

## Revendications

1. Procédé de mise en oeuvre d'un système de refroidissement du type redondant pour assurer une charge de refroidissement maximum prédéterminée à l'air dans un espace conditionné (111), le procédé comprenant :
la fourniture d'une pluralité d'unités de refroidissement d'air à flux de réfrigérant variable (101, 102, 103) comprenant un compresseur à vitesse variable, dans lequel le nombre d'unités de refroidissement d'air (101, 102, 103) est au moins égal à un de plus que requis pour satisfaire la charge de refroidissement maximum prédéterminée lors du fonctionnement des unités de refroidissement d'air (101, 102, 103) jusqu'à une capacité de refroidissement maximum ;
le couplage de la pluralité d'unités de refroidissement d'air à flux de réfrigérant variable (101, 102, 103) en termes de communication thermique avec l'air dans l'espace conditionné (111) ; et
la détermination d'une condition de fonctionnement optimum de sélection pour chacune de la pluralité d'unités de refroidissement d'air à flux de réfrigérant variable (101, 102, 103), laquelle condition conduira en tant que résultat à une consommation d'énergie globale la plus faible pour le système de refroidissement du type redondant, tout en maintenant une température moyenne de l'air dans l'espace conditionné (111) à un point de consigne requis ; et
a) la mise en fonctionnement des compresseurs à vitesse variable de chacune de la pluralité d'unités de refroidissement d'air à flux de réfrigérant variable (101, 102, 103) à approximativement la même vitesse que lorsque la sortie de refroidissement de chaque unité de refroidissement (101, 102, 103) est au-delà de celle à laquelle un rapport de rendement d'énergie maximum de l'unité est observé ; et
b) au moins une action prise parmi i) la coupure du fonctionnement des compresseurs à vitesse variable d'une ou de plusieurs de la pluralité d'unités de refroidissement d'air (101, 102, 103) lorsque la sortie de refroidissement requise moyenne de l'ensemble de la pluralité d'unités de refroidissement d'air (101, 102, 103) est en-deçà de celle à laquelle le rapport de rendement d'énergie maximum de l'unité de refroidissement d'air (101, 102, 103) est observé ; et ii) la mise en fonctionnement de chacune de la pluralité d'unités de refroidissement d'air (101, 102, 103) environ au niveau du point au niveau duquel le rapport de rendement d'énergie maximum de l'unité de refroidissement d'air (101, 102, 103) est observé.

2. Procédé selon la revendication 1, d'où il résulte que chacune des unités de refroidissement d'air à flux de réfrigérant variable (101, 102, 103) est associée à un contrôleur qui assure que la sortie de refroidissement de l'unité de refroidissement (101, 102, 103) est modifiée afin de commander la température de l'espace conditionné (111) de telle sorte qu'elle soit environ égale à celle du point de consigne de température.

3. Procédé selon la revendication 2, comprenant en outre :
la commande de la durée temporelle pendant laquelle le compresseur de chacune de la pluralité d'unités de refroidissement d'air (101, 102, 103) est mis en fonctionnement ; et
la commande de la durée temporelle pendant laquelle le compresseur de chacune de la pluralité d'unités de refroidissement d'air (101, 102, 103) est coupé en termes de fonctionnement, de telle sorte qu'une usure pour le compresseur de chacune des unités de refroidissement d'air (101, 102, 103) soit approximativement égalisée sur le temps.

4. Procédé selon la revendication 2 ou 3, comprenant en outre la communication d'une information afin de déterminer un point de fonctionnement optimum pour chaque unité de refroidissement (101, 102, 103) séparant le contrôleur qui est associé à chaque unité de refroidissement d'air à flux de réfrigérant variable (101, 102, 103), d'où il résulte que le contrôleur qui est associé à chaque unité (101, 102, 103) fournit et reçoit une information qui aboutira en tant que résultat à environ la consommation d'énergie globale la plus faible pour le système de refroidissement du type redondant et il met en fonctionnement chaque unité de refroidissement (101, 102, 103) environ au niveau du point de fonctionnement optimum déterminé.

5. Procédé selon la revendication 4, d'où il résulte que le contrôleur dans chaque unité de refroidissement d'air à flux de réfrigérant variable (101, 102, 103) incorpore un moyen de communication, et d'où il résulte que le contrôleur dans chaque unité (101, 102, 103) fournit une information qui concerne l'unité de refroidissement (101, 102, 103), laquelle permet de déterminer au moins un état pris parmi son état de fonctionnement et son état de défaillance, et d'où il résulte que les points de consigne d'unité de refroidissement peuvent être réglés.

6. Procédé selon l'une quelconque des revendications qui précèdent, d'où il résulte que chaque unité de refroidissement d'air à flux de réfrigérant variable (101, 102, 103) incorpore un moyen de pilotage à vitesse variable et de commande associée, le procédé comprenant en outre le réglage de la vitesse d'un ventilateur intérieur pour commander la capacité de refroidissement latente de l'unité de refroidissement (101, 102, 103).

7. Procédé selon l'une quelconque des revendications qui précèdent, comprenant en outre la mesure de l'humidité de l'espace conditionné (111) et le réglage de la capacité de refroidissement latente des unités de refroidissement (101, 102, 103) de manière à commander l'humidité de l'espace conditionné (111).

8. Procédé selon l'une quelconque des revendications qui précèdent, comprenant en outre le réglage de la vitesse d'un ventilateur intérieur qui est associé à une ou à plusieurs de la pluralité d'unités de refroidissement d'air à flux de réfrigérant variable (101, 102, 103) afin d'approximativement minimiser la consommation d'énergie de l'unité de refroidissement (101, 102, 103) pour une sortie de refroidissement sélectionnée.

9. Procédé selon l'une quelconque des revendications qui précèdent, comprenant en outre le réglage de la vitesse d'un ventilateur extérieur qui est associé à une ou à plusieurs de la pluralité d'unités de refroidissement d'air à flux de réfrigérant variable (101, 102, 103) afin d'approximativement minimiser la consommation d'énergie de l'unité de refroidissement (101, 102, 103) pour une sortie de refroidissement sélectionnée.

10. Procédé selon l'une quelconque des revendications qui précèdent, comprenant en outre :
la surveillance de l'état des unités de refroidissement individuelles (101, 102, 103) à l'aide d'un moyen de communication, et l'information d'état est utilisée en tant que l'une des entrées pour déterminer des conditions de défaillance ; et
la notification à un utilisateur ou à un membre du personnel de maintenance d'une condition de défaillance dans le système de refroidissement du type redondant.

11. Procédé selon l'une quelconque des revendications qui précèdent, comprenant en outre l'augmentation du coefficient de chaleur sensible du système en mettant en fonctionnement une ou plusieurs unité(s) sélectionnée(s) de la pluralité d'unités de refroidissement d'air à flux de réfrigérant variable (101, 102, 103) avec un flux d'air intérieur qui est proportionnellement plus élevé pour une sortie de refroidissement sélectionnée qu'un flux d'air intérieur maximum pour une sortie de refroidissement maximum.

12. Procédé selon l'une quelconque des revendications qui précèdent, comprenant en outre l'augmentation du MTBF de la pluralité d'unités de refroidissement d'air à flux de réfrigérant variable (101, 102, 103) en minimisant les pertes totales dans le système et en répartissant les pertes minimisées de façon uniforme entre toutes les unités de refroidissement (101, 102, 103).

13. Système de refroidissement pour assurer une charge de refroidissement maximum prédéterminée à l'air dans un espace conditionné (111), le système comprenant :
une pluralité d'unités de refroidissement d'air à flux de réfrigérant variable (101, 102, 103), dans lequel le nombre d'unités de refroidissement d'air (101, 102, 103) est au moins égal à un de plus que requis pour satisfaire la charge de refroidissement maximum prédéterminée lors de la mise en fonctionnement des unités de refroidissement d'air (101, 102, 103) jusqu'à une capacité de refroidissement maximum, et les unités de refroidissement d'air de la pluralité d'unités de refroidissement d'air à flux de réfrigérant variable (101, 102, 103) sont couplées en termes de communication thermique avec l'air dans l'espace conditionné (111) ; et
des moyens pour déterminer une condition de fonctionnement optimum de sélection pour chacune de la pluralité d'unités de refroidissement d'air à flux de réfrigérant variable (101, 102, 103), laquelle condition conduit en tant que résultat à une consommation d'énergie globale la plus faible pour le système de refroidissement du type redondant, tout en maintenant une température moyenne de l'air dans l'espace conditionné (111) à un point de consigne requis ;
les unités de refroidissement d'air à flux de réfrigérant variable (101, 102, 103) comprenant un compresseur à vitesse variable et dans lequel les compresseurs à vitesse variable de chacune de la pluralité d'unités de refroidissement d'air à flux de réfrigérant variable (101, 102, 103) disposent de la capacité de fonctionner à approximativement la même vitesse lorsque la sortie de refroidissement de chaque unité de refroidissement (101, 102, 103) est au-delà de celle à laquelle un rapport de rendement d'énergie maximum de l'unité est observé ; et
le système dispose de la capacité de réaliser au moins une action prise parmi a) la coupure du fonctionnement des compresseurs à vitesse variable d'une ou de plusieurs de la pluralité d'unités de refroidissement d'air (101, 102, 103) lorsque la sortie de refroidissement requise moyenne de l'ensemble de la pluralité d'unités de refroidissement d'air (101, 102, 103) est en-deçà de celle à laquelle le rapport de rendement d'énergie maximum de l'unité de refroidissement d'air est observé ; et b) la mise en fonctionnement de chacune de la pluralité d'unités de refroidissement d'air (101, 102, 103) environ au niveau du point au niveau duquel le rapport de rendement d'énergie maximum de l'unité de refroidissement d'air est observé.
